Europäisches Patentamt

European Patent Office

Office européen des brevets

(19)

(11) Publication number: **0 231 794**
**A2**

(12) # EUROPEAN PATENT APPLICATION

(21) Application number: **87100546.8**

(22) Date of filing: **16.01.87**

(51) Int. Cl.4: **H01L 21/285** , **H01L 21/268**

(30) Priority: **03.02.86 US 825175**

(43) Date of publication of application:
**12.08.87 Bulletin 87/33**

(84) Designated Contracting States:
**DE FR GB IT**

(71) Applicant: **International Business Machines Corporation**
**Old Orchard Road**
**Armonk, N.Y. 10504(US)**

(72) Inventor: **Iyer, Subramanian Srikanteswara**
**3081 Radcliff Drive**
**Yorktown Heights New York 10598(US)**
Inventor: **Rothenberg, Joshua Elliot**
**189 Columbus Ave. Apt. 1A**
**East White Plains New York 10604(US)**

(74) Representative: **Oechssler, Dietrich, Dr. rer. nat.**
**IBM Deutschland GmbH Patentwesen und Urheberrecht Schönaicher Strasse 220**
**D-7030 Böblingen(DE)**

(54) **Method and apparatus for forming metal silicide/silicon structures.**

(57) The method creates a smooth interface in a low resistance metal silicide/silicon structure particularly by the step of: Exposing the surface of a metal, like titanium, deposited on a silicon substrate radiation to reduce the oxide at said interface. On reacting said metal a metal silicide/silicon structure having a smooth interface is produced. The apparatus suitable for fabricating such structures comprises: A chamber for containing a metal/silicon structure, a pulsed laser device for producing pulses of ultraviolet radiation, and means for directing said pulses of ultraviolet radiation onto said metal silicide/silicon structure for causing an oxide reduction at said metal/silicon interface. The method and apparatus are used in forming -especially VLSI -integrated circuits.

FIG. 2

## Method and Apparatus for Forming Metal Silicide/Silicon Structures

The present invention relates to methods and apparatus used in fabricating integrated circuits having low resistance metal silicide/silicon contact structures.

As an example of a general prior art reference to the treatment of a surface, after coating, by a beam of radiation, see U.S. Patent 4 478 876. This reference teaches a method of coating a solid substrate with an abrasion resistant silicon hard coating composition which is curable upon exposure to ultraviolet radiation.

An object of the present invention is to provide a method and an apparatus for forming metal silicide/silicon structures having smooth interfaces.

Another object of the present invention is to provide a method for fabricating low resistance metal silicide/silicon contacts for integrated circuits with the contacts having smooth surfaces.

These objects are achieved by methods as disclosed in claim 1 and 2 and by an apparatus as disclosed in claim 8.

Advantageous embodiments of the inventive methods are disclosed in the subclaims.

The invention will become more apparent from the following detailed description taken in conjunction with the accompanying drawings.

Fig. 1 is a schematic illustration of a cross section of a silicide film used in the explanation of the present invention.

Fig. 2 is a schematic illustration of an apparatus, including a short pulse laser used in producing the method of the present invention.

Very Large Scale Integrated Circuit (VLSI) technology mandates the use of low resistivity interconnect materials at every level. In many applications, refractory silicides are usually employed. For example, deposited titanium is reacted on exposed silicon areas to form both Schottky and ohmic contacts as well as low resistance local interconnects.

One of the problems encountered in the use of thermally reacted titanium silicide is the extremely rough nature of the silicide surface, and silicide-silicon interface. This roughness leads to degraded pn junctions especially when the junction depths are shallow and rough surfaces are difficult to cover up by subsequently deposited layers such as passivations. The present invention provides a technique to obtain low resistance titanium silicide films with significantly less roughness than just thermally reacted films.

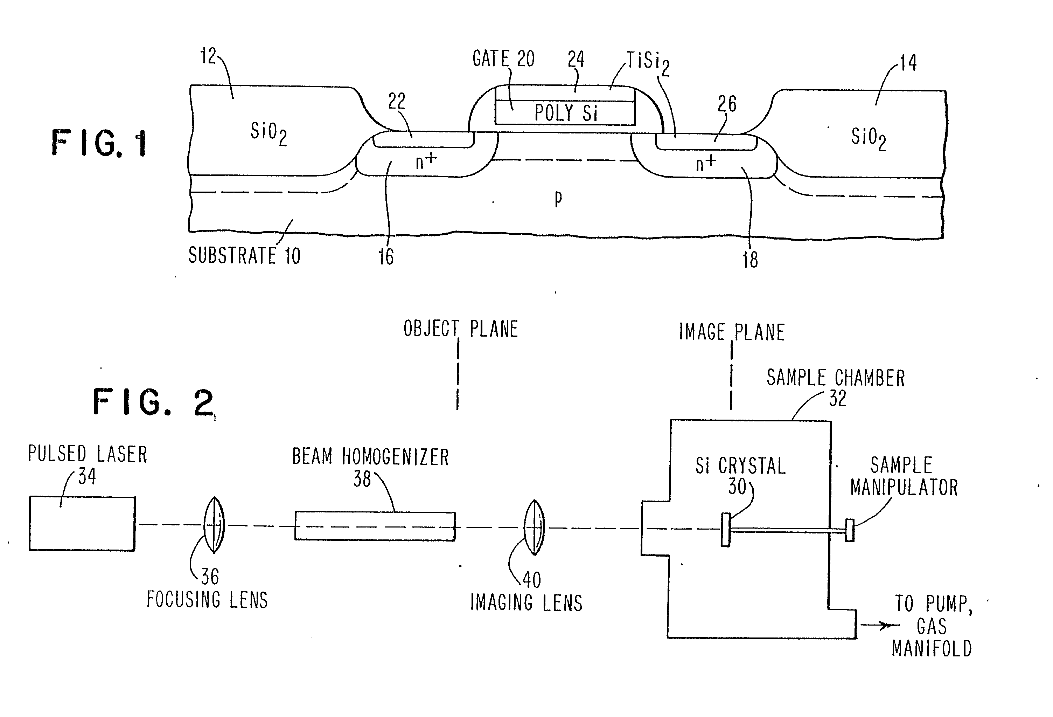

Referring to Fig. 1, the silicide film structure is shown including a silicon substrate 10 containing recessed oxide isolation regions 12 and 14, source and drain regions 16 and 18 and a polysilicon gate region 20. Titanium silicide films 22, 24 and 26 are located on the silicon gate, source and drain regions as contacts.

In the technique as illustrated in Fig. 1, the interface of the deposited titanium films on silicon is preconditioned by laser pretreatment by exposing the metal surface to several short (10 nanosec.) pulses of an excimer laser. The wavelength is sufficiently short that most of the radiation is absorbed in the metal and a temperature of greater than 500° C is established at the titanium/silicon interface momentarily by adjustment of the energy in the pulse.

The actual irradiation conditions are dependent on the thickness of the Ti film, and the interface cleanliness as well as incident laser fluence. The laser exposure is performed in a clean environment such as pure nitrogen or helium or even in a flushed vacuum chamber. After this treatment, the samples are annealed in the conventional manner.

The short pulse laser 12 radiation pretreatment causes the interfacial oxide to be cleaned up due to extremely local and rapid native oxide reduction by Ti at the interface with insufficient time to allow for any significant silicon diffusion. On thermal annealing therefore, an ultraclean interface promotes uniform nucleation of the silicide phase and thus a smooth surface and interface.

In a specific embodiment as shown in Fig. 2, several specimens of 50 nm Ti on single crystal Si were exposed to laser pulses. The silicon crystal 30 is located in chamber 32. A pulsed laser 34 provides radiation which passes through lens 36, beam homogenizer 38 and lens 40 and into chamber 32 where it impinges onto silicon crystal 30. Radiation of 248 nm from a krypton fluoride laser were employed. Fluences between 140 and 300 mJ/cm² were used and between one and 100 pulses were employed. The laser beam was homogenized in a light pipe and a fairly uniform beam of 1.3 cm $\times$ 1.3 cm was obtained. At the lower power levels the temperature rise at the interface is estimated to be less than 250° C, while at the higher power levels a temperature rise greatly exceeding 500° C may be estimated. These exposures were conducted in air. It may be conducted in vacuum or a controlled ambience to minimize any unintentional impurity incorporation. At all but the very highest fluences and number of pulses, negligible silicide formation was observed. This was also borne out by resistivity measurements. At this stage the films were annealed at 800° C in nitrogen.

Thus every specimen had two distinct areas: a square area in the center exposed to the laser pretreatment and the surrounding area that was only thermally treated. Resistance measurements were made on both areas on all samples. In all cases the resistance was about 1.5 ohms/square on both areas indicating a complete and good reaction. The surface morphology was then examined in several ways. When observed under oblique white light illumination, the pretreated areas in certain samples (300 mJ/cm² 4 pulses) reflected specularly while unpretreated area scattered randomly. Microscopy and physical measurement of the surface contours showed that the pretreated areas were smoother. Although the size of the irregularities were about the same, they were significantly less dense on the pretreated areas. Clearly, therefore by use of the present invention, significantly smoother surfaces are obtained and roughness is reduced to insignificant levels.

Thus, a laser pretreatment technique is described that results in extremely smooth titanium silicide films. This scheme is also applicable to other refractory reacted silicides that are prone to nonuniform nucleation of nonuniform initial interface conditions. The method is easily applicable to high throughput and exhibits a reasonably wide process window.

The invention comprises with other words a technique wherein the interface between a deposited metal silicide film and a silicon substrate is preconditioned by laser pretreatment by exposing the metal surface to several short (10 nanosec.) pulses of an ultraviolet laser. The wavelength is sufficiently short that most of the radiation is absorbed in the metal and a temperature of greater than 500° C is established at the metal/silicon interface momentarily by adjustment of the energy in the pulse.

The short pulse laser 14 radiation pretreatment causes the interfacial oxide to be cleaned up due to extremely local and rapid native oxide reduction by the metal at the interface with in sufficient time to allow for any significant silicon diffusion. On thermal annealing therefore, an ultraclean interface promotes uniform nucleation of the silicide phase and thus a smooth surface and interface.

## Claims

1. A method for creating a metal silicide/silicon structure comprising the steps of:

depositing a refractory metal on a silicon substrate to form a metal/silicon interface,

exposing said metal surface to short pulses of radiation to reduce the oxide at said interface,

reacting said refractory metal to produce a metal silicide/silicon structure having a smooth interface.

2. A method for fabricating low resistance film contact structures having metal silicide/silicon interfaces comprising the steps of:

providing a silicon substrate having device source, drain and gate regions therein

depositing a refractory metal on the surface of said source, drain and gate regions to form metal/silicon interfaces,

treating said structure by exposure to pulses of ultraviolet radiation to produce oxide reduction at said metal/silicon interfaces,

reacting said refractory metal on said silicon source drain and gate regions to form metal silicide/silicon interfaces, and

thermal annealing said structure to produce a structure having contacts with smooth surfaces.

3. A method according to claim 1 or 2 wherein said metal is titanium and said metal is titanium.

4. A method according to claim 3 wherein said silicon is single crystal silicon.

5. A method according to any one of claims 1 to 4 wherein said radiation is laser pulses in the order of 10 nonoseconds pulses from an excimer laser to produce a temperature in the range of less than 250° C and greatly exceeding 500° C at said titanium/silicon interface.

6. A method according to claim 5 wherein a 50 nm thick Ti layer on single crystal Si is exposed to said laser pulses at a wavelength of 248 nm and fluences between 140 and 300 mJ/cm².

7. A method according to any one of claims 3 to 6 wherein the fluence level is adjusted to a value achieving a temperature in the order of 500° C.

8. A method according to any one of claims 3 to 6 wherein the fluence level is adjusted to a value achieving a temperature greater than 500° C.

9. A method according to any one of claims 1 to 8 wherein the laser treatment is performed in a pure environment such as clean air, pure nitrogen or helium or a vacuum.

10. Apparatus being used in fabricating metal silicide/silicon structures comprising:

a chamber for containing a metal/silicon structure,

a pulsed laser device for producing pulses of ultraviolet radiation, and

means for directing said pulses of ultraviolet radiation onto said metal/silicon structure for causing an oxide reduction at said metal/silicon interface.

M – YO 985 066

0 231 794

**FIG. 1**

12 — SiO₂

GATE 20    24    TiSi₂

22

POLY Si

26    14 — SiO₂

16    n⁺    p    n⁺    18

SUBSTRATE 10    16    18

**FIG. 2**

OBJECT PLANE

IMAGE PLANE

SAMPLE CHAMBER 32

PULSED LASER 34

BEAM HOMOGENIZER 38

Si CRYSTAL 30

SAMPLE MANIPULATOR

36 FOCUSING LENS

40 IMAGING LENS

TO PUMP, GAS MANIFOLD